# EUROPÄISCHE PATENTSCHRIFT

(11) **EP 3 034 569 B1**
(45) Veröffentlichungstag und Bekanntmachung des Hinweises auf die Patenterteilung: **30.11.2016**
(21) Anmeldenummer: 14199251.1
(22) Anmeldetag: 19.12.2014
(51) Int. Cl.: C09D 5/00, C09D 133/10, C08J 3/24, C08J 3/28, C09D 4/06, C08F 220/18, C09D 133/08, C08F 2/48, C08F 2/46, B05D 3/06, G03F 7/004

(54) **Thermisch nachhärtende mit aktinischer Strahlung vernetzende Systeme**
Crosslinking systems which harden thermally by means of actinic radiation
Systèmes réticulables par durcissement ultérieur au moyen de rayonnement actinique

(43) Veröffentlichungstag der Anmeldung: 22.06.2016
(73) Patentinhaber: Evonik Degussa GmbH, 45128 Essen (DE)
(72) Erfinder: Spyrou, Emmanouil, 46514 Schermbeck (DE); Tuncay, Zuhal, 44623 Herne (DE); Diesveld, Andrea, 48712 Gescher (DE); Ewald, Marion, 45768 Marl (DE); Loesch, Holger, 44627 Herne (DE)

(56) Entgegenhaltungen:
- US-A- 5 128 387
- US-A1- 2010 227 942

## Beschreibung

Die vorliegende Erfindung betrifft neue, mit aktinischer Strahlung und thermisch härtbare Formulierungen. Außerdem betrifft die vorliegende Erfindung die Verwendung der neuen mit aktinischer Strahlung und thermisch härtbaren Formulierungen für die Herstellung von pigmentierten und pigmentfreien Lacken sowie für Kleb- und Dichtstoffe.

Mit aktinischer Strahlung härtbare Formulierungen sind bekannt.

Ethylenische ungesättigte Prepolymere werden z. B. in P. K. T. Oldring (Hrsg.), "Chemistry and Technology of UV- and EB-Formulations for Coatings, Inks and Paints", Vol. II. SITA Technology, London 1991 beschrieben, beispielsweise auf Basis von Epoxyacrylaten (Seiten 31 bis 68), Urethanacrylaten (Seiten 73 bis 123) und Melaminacrylaten (Seiten 208 bis 214). Auch in der Patentliteratur finden solche Formulierungen häufig Erwähnung, exemplarisch seien genannt JP 62110779 und EP 947 565.

Nachteil solcher strahlenhärtbaren Formulierungen ist meist eine geringe Flexibilität aber auch die Einschränkung, dass in erster Linie flache Substrate zur Beschichtung in Frage kommen. Zwar hat es in den letzten Jahren nicht an Methoden gefehlt, auch dreidimensionale Substrate auf diese Weise zu beschichten, z.B. durch mechanische Vorrichtungen, die entweder das Substrat drehen, oder aber die Lampen bewegen, durch eine ausgeklügelte Spiegeltechnik oder durch Plasmakammern. Aber der nicht unbeträchtliche zusätzliche Aufwand hat solche Anwendungen weitestgehend auf Nischen beschränkt.

Die Beschichtung von metallischen Untergründen stellt ein besonderes Problem für Strahlen härtbare Formulierungen dar, da es aufgrund von Schrumpfungsprozessen zu einem Haftungsverlust kommen kann. Daher werden für solche Untergründe häufig phosphorsäurehaltige Haftvermittler eingesetzt. Beispiele dafür sind US 5,128,387 (Beschichtung von Bierdosen) und JP 2001172554 (Beschichtung von diversen Dosen).

Bekanntermaßen zeigen Epoxyacrylate eine hervorragende Haftung sowie einen guten Korrosionsschutz auf Metalluntergründen. Nachteil solcher Beschichtungen ist aber die geringe Verformbarkeit nach der Aushärtung. Für einige Beschichtungstechnologien, z. B. Coil-Coating ist die Verformbarkeit der beschichteten Werkstücke ohne Bildung von Rissen in der Beschichtung ausschlaggebend. Außerdem neigen solche Beschichtungen aufgrund ihrer aromatischen Anteile zum Vergilben.

WO 03/022945 beschreibt niederviskose Strahlen härtbare Formulierungen für Metalluntergründe auf Basis von Strahlen härtbaren Harzen, monofunktionellen Reaktivverdünnern und sauren Haftvermittlern. Die eingesetzten Harze sind dabei übliche, bei verschiedenen Anbietern erhältliche Verkaufsprodukte.

Auch EP 902 040 betrifft Strahlen härtbare Formulierungen. Darin werden Urethan(meth)acrylate mit monofunktionellen Estern einer ungesättigten Carbonsäure beschrieben, welche mit Alkoholen verestert sind, die einen Carbocyclus oder einen Heterocyclus enthalten.

Die aus dem Stand der Technik bekannten Systeme zeigen aber vielfach Nachteile, insbesondere die Aushärtung von dreidimensionalen Substraten in den Schattenzone ist schwierig bis gar nicht zu bewerkstelligen.

Daher werden seit einiger Zeit Dual Cure Systeme propagiert, die neben der Härtung durch Strahlen noch andere Härtungsmethoden beinhalten. Z. B. WO2001/46286, WO200146285, WO2001/42329, WO2001/23453, WO2000/39183, EP1138710, EP1103572, EP1085065, EP928800. In diesen wird die Reaktion von Isocyanat-funktionalisierten Bindemittelbestandteilen mit hydroxyfunktionellen Komponenten beschrieben, die zu einer zusätzlichen Vernetzung führt.

Setzt man hierbei freie Isocyanate ein, wie z. B. in WO2001/46286 so resultiert dies in einer 2K-Formulierung mit beschränkter Topfzeit.

Werden dagegen extern blockierte Isocyanate (z. B. WO2001/23453) verwendet, so kommt es während der Aushärtungsreaktion zu einer Freisetzung von Blockierungsmittel in die Umwelt, welche aus ökologischen Gründen unerwünscht ist.

Die Verwendung von intern blockierten Isocyanaten (Uretdionen) in Dual Cure Systemen wird in WO 03/016376 beschrieben. Dort führt die Verwendung von uretdionhaltigen Komponenten zu einer verbesserten Zwischenhaftung, hat aber in den aufgeführten Beispielen keinen Einfluss auf Härte und Kratzfestigkeit der Beschichtung (Beispiele 3, 4 und V2). In keinem Beispiel wird die Performance der Beschichtung allein mit thermischer Aushärtung, ohne Strahlenhärtung (eine Simulation der Schattenbereiche also) wiedergegeben. Außerdem sind Isocyanate vergleichsweise kostspielig.

Die thermische Nachhärtung von strahlenhärtbaren Formulierungen ist vor allem für kationisch initiierte Systeme lang bekannt. Bei radikalisch photopolymerisierten Formulierungen ist dies weniger üblich und beschränkt sich im Regelfall auf sterisch gehinderte Radikale (siehe dazu "Dark Reactions of Free Radicals Trapped in Densely Crosslinked Polymer Networks After Photopolymerization" in Journal of Applied Polymer Science, Vol. 89, 579-588 (2003) © 2003 Wiley Periodicals, Inc.)

Aufgabe der vorliegenden Erfindung war es, mit aktinischer Strahlung und thermisch härtbare Formulierungen zu entwickeln, die nach thermischer Aushärtung und vorheriger Strahlenhärtung eine Beschichtung, eine Verklebung oder eine Dichtung ergeben, die Minimalanforderungen erfüllt, also klebfrei, flexibel und chemikalienbeständig ist. Außerdem soll diese Formulierung aus Umweltschutzgründen frei von Blockierungsmitteln sein und unterhalb von 160 °C auszuhärten sein, um auch für temperaturempfindliche Substrate in Frage zu kommen. Insbesondere sollte es die Möglichkeit geben, eine Beschichtung teilweise mit Strahlung zu härten, danach das Substrat weiter zu bearbeiten, z. B. Verformen, Verkleben, Überlackieren und dann die Beschichtung vollständig auszuhärten.

Überraschend wurde gefunden, dass das erfindungsgemäße Verfahren die Aufgabenstellung erfüllt.

Gegenstand der vorliegenden Erfindung ist ein Verfahren zur Herstellung von Beschichtungen durch
I) Auswahl des ausgewählt Photoinitiator B) gemäß der folgenden Methode und mit der folgenden Bedingung: 2 Gew.-% des Photoinitiators werden in Isobornylacrylat gelöst, und auf einem Substrat mittels einer UV-Lampe 20-80 % der Doppelbindungen radikalisch polymerisiert mit einer Schichtdicke von 100 µm, wobei eine Beschichtung mit einem Maximum des exothermen Peaks in Grad Celsius bei Temperaturen kleiner oder gleich 160 °C, gemessen mittels DSC gemäß der DIN EN ISO 11357-1, erhalten wird;
II) Aushärtung von thermisch und Strahlen härtbaren Formulierungen aus
   A) 45 bis 99,9 Gew.-% mindestens einer Strahlen härtbaren Komponente Und
   B) 0,1 bis 5 Gew.-% mindestens eines ausgewählten radikalisch initiierenden Photoinitiators; und gegebenenfalls
   C) 0,01 bis 50 Gew.-% mindestens eines Zuschlagstoffes,
      und die Summe aus A) und B) und gegebenenfalls C) 100 Gew.-% ergibt,
   wobei diese Formulierung nach Applikation auf ein Substrat zunächst teilweise mit Strahlen ausgehärtet wird, wobei im Mittel mindestens 20 % bis maximal aber 95 % der polymerisierbaren Doppelbindungen zur Reaktion gebracht werden, danach das beschichtete Substrat weiterverarbeitet wird, und dann die Beschichtung auf dem Substrat thermisch bei von 60 bis 220 °C erhitzt, und die Beschichtung vollständig ausgehärtet wird.

Der ausgewählte Photoinitiator entspricht der folgenden Bedingung: 2 Gew.-% des Photoinitiators werden in Isobornylacrylat gelöst, und auf einem Substrat mittels einer UV-Lampe 20-80 % der Doppelbindungen radikalisch polymerisiert mit einer Schichtdicke von 100 µm, wobei eine Beschichtung mit einem Maximum des exothermen Peaks in Grad Celsius bei Temperaturen kleiner oder gleich 160 °C, gemessen mittels DSC gemäß der DIN EN ISO 11357-1, erhalten wird.

Die thermisch und Strahlen härtbaren Formulierungen haben den Vorteil, dass sie durch einen zweistufigen Härtungsprozess erhalten werden, ohne aber wie in herkömmlichen Dual-cure Systemen eine zweite Vernetzungskomponente benötigen.

Ein wesentlicher Bestandteil der Formulierungen sind die Strahlen härtbaren Harze der Komponente A). Hierbei handelt es sich um für den Fachmann bekannte Systeme. Die Herstellung Strahlen härtbarer Harze, Oligomere und/oder Polymere, wird z. B. in "Radiation Curing in Polymer Science & Technology, Vol I: Fundamentals and Methods" von J. P. Fouassier, J. F. Rabek, Elsevier Applied Science, London und New York, 1993, Chapter 5, Seiten 226 bis 236; in "Lackharze", D. Stoye, W. Freitag, Hanser-Verlag, Wien, 1996 , Seite 85, 94-98, 169 und 265 und in der EP 947 565 beschrieben.

Als Harze der Komponente A) sind beispielsweise Epoxyacrylate, Polyesteracrylate, Polyetheracrylate, Polyacrylatacrylate, Urethanacrylate und/oder Polyesterurethanacrylate, allein oder in Mischungen, geeignet. Im Falle der Urethanacrylate können diese z. B. auf Polyestern oder aber auch auf Polyethern basieren. Auch die entsprechenden Methacrylate sind bekannt. Andere Verbindungen mit polymerisationsfähigen Gruppen sind Epoxide und Vinylether. Auch diese können an verschiedenen Basisharzen angebunden sein.

Für A) kommen auch flüssige Strahlen härtbare Komponenten, sogenannte Reaktivverdünner in Frage.

Strahlen härtbare Reaktivverdünner A) und ihre Herstellung werden z. B. in "Radiation Curing in Polymer Science & Technology, Vol I: Fundamentals and Methods" von J. P. Fouassier, J. F. Rabek , Elsevier Applied Science, London und New York, 1993, Chapter 5, Seiten 237 bis 240 beschrieben. Es handelt sich dabei in der Regel um Acrylat oder Methacrylat haltige Stoffe, die bei Raumtemperatur flüssig und damit in der Lage sind, die Gesamtviskosität der Formulierung herabzusetzen. Beispiele für solche Reaktivverdünner sind Isobornylacrylat (IBOA), Hydroxypropylmethacrylat, Trimethylolpropanmonoformalacrylat, Tetrahydrofufurylacrylat, Phenoxyethylacrylat Trimethylenpropantriacrylat, Dipropylenglycoldiacrylat, Tripropylenglycoldiacrylat, Hexandioldiacrylat, Pentaerythrittetraacrylat, Laurylacrylat, sowie propoxilierte oder ethoxilierte Varianten dieser Reaktivverdünner und/oder urethanisierte Reaktivverdünner wie EBECRYL 1039 (Cytec), und werden allein oder in Mischungen eingesetzt. Außerdem in Frage kommen auch andere flüssige Komponenten, die in der Lage sind, unter Bedingungen der radikalischen Polymerisation mit z. B. Vinylether oder Allylether zu reagieren.

Die Menge A) in der Formulierung variiert von 45 bis 99,9 Gew.-%, bevorzugt 10 bis 50 Gew.-%, bezogen auf die Gesamtformulierung. Besonders bevorzugt sind Polyesterurethanacrylate. Beispiele dafür sind VESTICOAT EP 110 IBOA (Handelsprodukt der Evonik Industries AG, Deutschland, Coatings & Colorants, Difunktionelles Polyesterurethanacrylat) und EBECRYL 1256 (Handelsprodukt von Cytec, Trifunktionelles Polyesterurethanacrylat). Besonders bevorzugt werden auch monofunktionelle Reaktivverdünner, insbesondere Isobornylacrylat und/oder Trimethylolpropanmonoformalacrylat.

Bevorzugt werden als Komponente A) Mischungen aus Harzen der Komponente A) wie oben beschrieben und monofunktionelle Reaktivverdünner eingesetzt.

Mögliche geeignete Photoinitiatoren (PI) B) und ihre Herstellung werden z. B. in "Radiation Curing in Polymer Science & Technology, Vol II: Photoinitiating Systems" von J. P. Fouassier, J. F. Rabek, Elsevier Applied Science, London und New York, 1993 beschrieben. Häufig handelt es sich hierbei um α-Hydroxyketone bzw. deren Derivate. Die PI können in Mengen von 0,1 bis 10 Gew.-% bezogen auf die Gesamtformulierung, enthalten sein. Entscheidend für die Eignung der speziellen PI ist die Eigenschaft, nach einer Bestrahlung mit UV-Strahlen bei Temperaturen ≤ 160 °C weiterhin noch thermisch aktivierbar zu sein. Dies wird durch einen Vorversuch getestet bei dem ein Reaktivverdünner, IBOA mit 2 Gew.-% PI versehen wird. Diese Mischung wird unter einer UV-Lampe teilweise zu 20 - 80 % radikalisch polymerisiert und anschließend einer DSC-Messung unterworfen. Wenn das Maximum des exothermen Peaks in Grad Celsius bei Temperaturen ≤ 160 °C liegt, gemessen mittels DSC gemäß der DIN EN ISO 11357-1, ist dieser PI geeignet. Sieht man keinen exothermen Peak oder liegt dieser oberhalb von 160°C, ist der betreffende PI nicht geeignet. Besonders geeignet sind Photoinitiatoren, wenn der exotherme Peak unter 140 °C liegt.

Geeignete Photoinitiatoren sind z. B. CHIVACURE 300 (Oligo[2-hydroxy-2-methyl-1-[4-(1-methylvinyl)phenyl]propanone], CAS-No.: 163702-01-0) und CHIVACURE 534 (Bis(η5-2,4-cylcopentadien-1-yl)-bis(2,6-difluoro-3-(1H-pyrrol-1-yl)-phenyl)titanium CAS-No.: 125051-32-3) (Chitec), IRGACURE 184 (CAS No.: 947-19-3, 1-Hydroxycyclohexyl-phenylketon), IRGACURE 651 (2,2-Dimethoxy-1,2-diphenylethan-1-on, CAS-No.: 24650-42-8) und IRGACURE 819 (BASF) (Phenyl-bis(2,4,6-trimethylbenzoyl)-phosphinoxid, CAS-No.: 162881-26-7), DAROCURE 1173 (2-Hydroxy-2-benzoylpropan, CAS-No.: 7473-98-5) (BASF).
Als Zuschlagstoffe C) kommen insbesondere Haftvermittler, Pigmente, Inhibitoren, Stabilisatoren, Entgasungsmittel, Verlaufsmittel, Lösemittel in Frage.

Optional können die erfindungsgemäßen Formulierungen Haftvermittler C) enthalten. In der Regel bestehen Haftvermittler für Strahlen härtbare Formulierungen für metallische Untergründe aus Phosphorsäure und/oder Phosphonsäure und/oder deren Umsetzungsprodukten (z. B. Ester) mit funktionalisierten Acrylaten. Während die freien Phosphorsäuregruppen für die direkte Haftung auf dem Metall verantwortlich sind, sorgen die Acrylatgruppen für einen Verbund mit der Beschichtungsmatrix. Solche Produkte werden beispielsweise beschrieben in WO 01/98413, in JP 08231564, und in JP 06313127, deren Offenbarung hiermit unter Bezugnahme mit eingeschlossen ist.

Typische Handelsprodukte sind EBECRYL 168, 169 und 170 von Cytec, ALDITOL Vxl 6219 von VIANOVA, CD 9050 und CD 9052 von Sartomer, SIPOMER PAM-100, SIPOMER PAM-200 und SIPOMER PAM-300 von Rhodia und GENORAD 40 von Rahn.

Geeignete Pigmente C) für die Strahlen härtbaren Formulierungen gemäß der vorliegenden Erfindung werden, z. B. in "Radiation Curing in Polymer Science & Technology, Vol IV: Practical Aspects and Application" von J. P. Fouassier, J. F. Rabek , Elsevier Applied Science, London und New York, 1993, Chapter 5, Seiten 87 bis 105 beschrieben und können in Mengen von 1 bis 40 Gew.-% enthalten sein. Beispiele für Korrosionsschutzpigmente findet man z. B. in Pigment + Füllstoff Tabellen, O. Lückert, Vincentz Verlag Hannover, 6. Auflage 2002. Beispielhaft seien genannt: SHIELDEX C 303 (Grace Davison) und HALOX Coil X 100, HALOX Coil X 200 und HALOX CW 491 (Erbslöh), HEUCOPHOS SAPP oder auch ZPA (Heubach), K-White TC 720 (Tayca) und HOMBICOR (Sachtleben). Natürlich kommen auch einfache anorganische Salze wie z. B. Zinkphosphat oder auch farbgebende Pigmente in Betracht. Die Menge an solchen Pigmenten variiert von 1 bis 50 Gew.-%, bezogen auf die Gesamtformulierung, falls vorhanden.

Sonstige Zuschlagstoffe C) für die Strahlen härtbaren Formulierungen gibt es in verschiedenen Zusammensetzungen und für diverse Zwecke.

Einige von Ihnen werden beschrieben in der Broschüre "SELECTED DEGUSSA PRODUCTS FOR RADIATION CURING AND PRINTING INKS", herausgegeben von der Tego Coating & Ink Additives, Essen, 2003. Die Menge an solchen Additiven variiert von 0,01 bis 5 Gew.-%, bezogen auf die Gesamtformulierung, falls vorhanden.

Als Lösemittel C) kommen alle flüssigen unter den Reaktionsbedingungen inerten organischen und anorganischen Flüssigkeiten in Frage. Als Beispiele seien genannt Aceton, Ethylacetat, Butylacetat, Xylol, Solvesso 100, Solvesso 150, Methoxypropylacetat und Dibasicester und Wasser.

Die Menge an Lösemittel beträgt 1-50 Gew.-% bezogen auf die Gesamtformulierung, falls vorhanden.

Die Homogenisierung aller Bestandteile zur Herstellung der erfindungsgemäßen Zusammensetzung kann in geeigneten Aggregaten, wie z. B. beheizbaren Rührkesseln, Knetern oder auch Extrudern, erfolgen, wobei Temperaturobergrenzen von 120 bis 130 °C nicht überschritten werden sollten.

Die gut vermischte Masse wird durch geeignete Auftragung, (z. B. Walzen, Sprühen, Spritzen, Tauchen) auf das Substrat aufgebracht. Nach dem Auftrag werden die beschichteten Werkstücke zur Aushärtung in Anwesenheit von Photoinitiatoren unter eine UV Lampe (mit oder ohne Schutzgas) geführt. Die Strahlendosis wird so bemessen, dass die Aushärtung noch nicht vollständig ist. Dazu werden im Mittel mindestens 20 %, maximal aber 95 % der polymerisierbaren Doppelbindungen zur Reaktion gebracht. Gemessen wird der Grad der Aushärtung entweder mit einem IR-Spektrometer oder mit einem Fourier-Transform-Infrarotspektrometer (FTIR-Spektroskopie) durch Messung und Bestimmung der noch vorhandenen Doppelbindungen der Komponente A). Dazu wird die Intensität der Banden bei 1200 und 1280 cm⁻¹ zu Grunde gelegt. Diese Methode ist dem Fachmann bekannt, siehe z.B. Hans-Ulrich Gremlich, Helmut Günzler: IR-Spektroskopie: Eine Einführung. 4. Auflage. Wiley-VCH, 2003; Griffiths, P.; de Hasseth, J.A. (18 May 2007). Fourier Transform Infrared Spectrometry (2nd ed.). Wiley-Blackwell. ISBN 0-471-19404-2.

Nach einem möglichen weiteren Arbeitsschritt, z. B. Verformung, Überlackierung, Kaschierung, wird 4 bis 60 Minuten auf eine Temperatur von 60 bis 220 °C, vorzugsweise 6 bis 30 Minuten bei 80 bis 160 °C erhitzt, und die Beschichtung vollständig thermisch ausgehärtet.

UV-Härtung und geeignete UV-Lampen werden z. B. beschrieben in "Radiation Curing in Polymer Science & Technology, Vol I: Fundamentals and Methods" von J. P. Fouassier, J. F. Rabek, Elsevier Applied Science, London and New York, 1993, Chapter 8, Seiten 453 bis 503.

Die Beschichtung kann entweder allein verwendet werden, oder eine Schicht eines Mehrschichtaufbaus sein. Sie kann beispielsweise als Primer, als Zwischenschicht oder als Deck- oder Klarlack aufgetragen sein. Die über oder unter der Beschichtung liegenden Schichten können entweder konventionell thermisch ausgehärtet werden, oder aber auch durch Strahlung.

Nachfolgend wird die vorliegende Erfindung anhand von Beispielen näher erläutert. Alternative Ausführungsformen der vorliegenden Erfindung sind in analoger Weise erhältlich.

### Beispiele:

**Tabelle 1**

| **Einsatzstoffe** | **Produktbeschreibung, Hersteller** |
|---|---|
| DYNAPOL R 110 | Strahlenhärtbares Harz, Urethanacrylat 75 Gew.-% in 25 Gew.-% Isobornylacrylat, Evonik Industries AG, Coatings & Additives |
| IRGACURE 184 | Photoinitiator, BASF |
| IRGACURE 651 | Photoinitiator, BASF |
| IRGACURE 651 | Photoinitiator, BASF |
| CHIVACURE | Photoinitiator, Chitec |
| CHIVACURE | Photoinitiator, Chitec |
| DAROCURE | Photoinitiator, BASF |
| H-Nu-4701L* | Photoinitiator, Spectra |
| IRGACURE 2959* | Photoinitiator, BASF |
| IRGACURE 127* | Photoinitiator, BASF |
| Isobornylacrylat | Reaktivverdünner, Aldrich |
| Hexandioldiacrylat | Reaktivverdünner, Aldrich |

| | |
|---|---|
| *nicht erfindungsgemäße Vergleichsbeispiele | |

### A) Vorversuche

Isobornylacrylat wird mit 2 Gew.-% eines Photoinitiators gemischt und auf ein Stahlblech (Q-Panel R36) mit einer Kastenrakel (100 µm). aufgebracht.
Dann wurde unter mit einer UV-LED Lampe (Heraeus NobleCure® basierend auf wassergekühlter Wärmesenke Wellenlänge: 395±5nm, Leistungsdichte: 8W/cm² in 5mm Arbeitsabstand Emissionsfenster: 251 x 35mm²) 5 s getrocknet.

Dabei wurden im Mittel etwa 30-70 % der Doppelbindungen polymerisiert.

Danach wurde eine Probe von der Beschichtung entnommen und per DSC (Mettler DSC I, 10 K/min) analysiert. Das Maximum des exothermen Peaks in Grad Celsius ist in der nachfolgenden Tabelle 2 aufgeführt. Die so hergestellten Mischungen und Beschichtungen mit einem Maximum des exothermen Peaks in Grad Celsius von kleiner oder gleich 160 °C sind erfindungsgemäß geeignet.

**Tabelle 2**

| Versuch/Komponente | Maximum Exothermie [°C] mittels DSC: |
|---|---|
| IRGACURE 184 | 159 |
| IRGACURE 651 | 135 |
| IRGACURE 819 | 108 |
| CHIVACURE 300 | 154 |
| CHIVACURE 534 | 142 |
| DAROCURE 1173 | 151 |
| H-Nu-470IL* | 161 |
| IRGACURE 2959* | 172 |
| IRGACURE 127* | 163 |

| | |
|---|---|
| *nicht erfindungsgemäße Vergleichsbeispiele | |

### B) Beschichtungsexperimente

### 1) Erfindungsgemäß:

100 g DYNAPOL R 110 und 125 g Isobornylacrylat wurden mit 4,5 g IRGACURE 819 gemischt und mit einer 50 µm Rakel auf ein Stahlblech (Q-Panel R 36) aufgebracht. Danach wird mit einem UV-Gerät (Minicure, Quecksilberdampflampe, 80W/cm) 2x5m/min zu etwa 80 % der Doppelbindungen (FTIR) ausgehärtet. Die Beschichtung ist klebfrei und weist eine Erichsentiefung (DIN 53156) von 9 mm auf. Der T-Bend (DIN EN 13523-7) beträgt 3. Nach einer weiteren thermischen Aushärtung (15 min bei 150 °C) steigt der T-Bend auf >4.

### 2) Erfindungsgemäß:

100 g DYNAPOL R 110, 100 g Isobornylacrylat und 25 g Hexandioldiacrylat wurden mit 4,5 g IRGACURE 819 gemischt und mit einer 50 µm Rakel auf ein Stahlblech (Q-Panel R 36) aufgebracht. Danach wird mit einem UV-Gerät (Minicure, Quecksilberdampflampe, 80W/cm) 2x5m/min ausgehärtet zu etwa 80 % der Doppelbindungen. Die Beschichtung ist klebfrei und weist eine Erichsentiefung von 9,5 mm auf. Der T-Bend beträgt 2. Nach einer weiteren thermischen Aushärtung (15 min bei 150 °C) steigt der T-Bend auf 4.

### A) Nicht erfindungsgemäß, Vergleich:

100 g DYNAPOL R 110 und 125 g Isobornylacrylat wurden mit 4,5 g IRGACURE 2959 gemischt und mit einer 50 µm Rakel auf ein Stahlblech (Q-Panel R 36) aufgebracht. Danach wird mit einem UV-Gerät (Minicure, Quecksilberdampflampe, 80W/cm) 2x5m/min zu etwa 75 % der Doppelbindungen ausgehärtet. Die Beschichtung ist klebfrei und weist eine Erichsentiefung von 9 mm auf. Der T-Bend beträgt 3. Nach einer weiteren thermischen Aushärtung (15 min bei 150 °C) bleibt der T-Bend unverändert bei 3.

Im erfindungsgemäßen Fall steigt die Vernetzungsdichte nach der thermischen Aushärtung weiter an, die Flexibilität sinkt. Im nicht erfindungsgemäßen Fall steigt die Vernetzungsdichte nicht weiter an.

Die erfindungsgemäß hergestellten Formulierungen sind den nicht erfindungsgemäß hergestellten Formulierungen in allen Lackdaten überlegen. Vor allem zeigt die erfindungsgemäß hergestellte Formulierung nach thermischer Härtung auch ohne vorherige Strahlenhärtung eine Mindestmaß an Lackeigenschaften: Klebfreiheit, Flexibilität (Erichsentiefung > 7 mm) und Chemikalienbeständigkeit (MEK-Test > 20 Doppelhübe).

### Meßmethoden

Erichsentiefung nach DIN 53156, Kugelschlag nach ASTM D 2794-93
Meßmethode T-Bend (Biegeprüfung) nach DIN EN 13523-7
DSC-Messungen

Die DSC-Messungen wurden gemäß der DIN EN ISO 11357-1 vom März 2010 durchgeführt. Es wurde ein Wärmestrom-Differenz-Kalorimeter des Hersteller *Mettler-Toledo Modell: DSC 821 mit der Seriennr.: 5116131417 verwendet.* Die Proben werden einmal von -30 °C bis 250 °C mit 10 K/min gefahren.

Ausführliche Beschreibung der Meßmethode:
1. Typ (Wärmestrom-Differenz-Kalorimeter oder leistungskompensiertes Kalorimeter), Modell und Hersteller des verwendeten DSC-Geräts;
2. Werkstoff, Art und Typ sowie, wenn erforderlich, Masse der verwendeten Tiegel;
3. Art, Reinheitsgrad und Mengenstrom des verwendeten Spülgases;
4. Art des Kalibrierverfahrens und Einzelheiten zu den verwendeten Kalibriersubstanzen, einschließlich Quelle, Masse und weiterer für die Kalibrierung bedeutender Eigenschaften;
5. Einzelheiten zur Probenahme, Probekörpervorbereitung und Konditionierung

1: Wärmestrom-Differenz-Kalorimeter
   Hersteller: Mettler-Toledo
   Modell: DSC 821
   Seriennr.: 5116131417
2: Tiegelmaterial: Reinstaluminium
   Grösse: 40 µl , ohne pin,
   Mettler Best.-Nr.: ME-26763
   Masse incl. Deckel: ca. 48 mg
3: Spülgas: Stickstoff
   Reinheitsgrad: 5.0 (> 99,999 Vol.%) Mengenstrom: 40 ml/min
4: Kalibrierverfahren: einfach
   Material 1: Indium
   Mettler-Calibrier-Set ME-51119991
   Masse: ca. 6 mg pro Einwaage
   Kalibrierung von Temperatur (Onset) und Wärmestrom Material 2: VE-Wasser
   Entnahme aus dem Haussystem
   Masse: ca. 1 mg pro Einwaage
   Kalibrierung der Temperatur (Onset)
5: Probennahme: aus angeliefertem Probenfläschchen
   Probeneinwaage: 8 bis 10 mg
   Probenvorbereitung: mittels Stempel am Tiegelboden angepresst
   Tiegeldeckel: gelocht
   Meßprogramm: -30 bis 250 °C 10K/min 1x

## Patentansprüche

1. Verfahren zur Herstellung von Beschichtungen durch
I) Auswahl des ausgewählt Photoinitiator B) gemäß der folgenden Methode und mit der folgenden Bedingung:
2 Gew.-% des Photoinitiators werden in Isobornylacrylat gelöst, und auf einem Substrat mittels einer UV-Lampe 20-80 % der Doppelbindungen radikalisch polymerisiert mit einer Schichtdicke von 100 µm, wobei eine Beschichtung mit einem Maximum des exothermen Peaks in Grad Celsius bei Temperaturen kleiner oder gleich 160 °C, gemessen mittels DSC gemäß der DIN EN ISO 11357-1, erhalten wird;
II) Aushärtung von thermisch und Strahlen härtbaren Formulierungen aus
A) 45 bis 99,9 Gew.-% mindestens einer Strahlen härtbaren Komponente
und
B) 0,1 bis 5 Gew.-% mindestens eines ausgewählten radikalisch initiierenden Photoinitiators; und gegebenenfalls
C) 0,01 bis 50 Gew.-% mindestens eines Zuschlagstoffes,
und die Summe aus A) und B) und gegebenenfalls C) 100 Gew.-% ergibt,
wobei diese Formulierung nach Applikation auf ein Substrat zunächst teilweise mit Strahlen ausgehärtet wird, wobei im Mittel mindestens 20 % bis maximal aber 95 % der polymerisierbaren Doppelbindungen zur Reaktion gebracht werden,
danach das beschichtete Substrat weiterverarbeitet wird,
und dann die Beschichtung auf dem Substrat thermisch bei von 60 bis 220 °C erhitzt, und die Beschichtung vollständig ausgehärtet wird.

2. Verfahren zur Herstellung von Beschichtungen durch Aushärtung von thermisch und Strahlen härtbaren Formulierungen nach Anspruch 1,
wobei der ausgewählte Photoinitiator der folgenden Bedingung entspricht:
2 Gew.-% des Photoinitiators werden in Isobornylacrylat gelöst, und auf einem Substrat mittels einer UV-Lampe 20-80 % der Doppelbindungen radikalisch polymerisiert mit einer Schichtdicke von 100 µm, wobei eine Beschichtung mit einem Maximum des exothermen Peaks in Grad Celsius bei Temperaturen kleiner oder gleich 160 °C, gemessen mittels DSC gemäß der DIN EN ISO 11357-1, erhalten wird.

3. Verfahren zur Herstellung von Beschichtungen durch Aushärtung von thermisch und Strahlen härtbaren Formulierungen nach mindestens einem der vorherigen Ansprüche,
**dadurch gekennzeichnet,**
**dass** als Harze der Komponente A) Epoxyacrylate, Polyesteracrylate, Polyetheracrylate, Polyacrylatacrylate, und Urethanacrylate und/oder Polyesterurethanacrylate, allein oder in Mischungen enthalten sind.

4. Verfahren zur Herstellung von Beschichtungen durch Aushärtung von thermisch und Strahlen härtbaren Formulierungen nach mindestens einem der vorherigen Ansprüche,
**dadurch gekennzeichnet,**
**dass** als Komponente A) Polyesterurethanacrylate enthalten sind.

5. Verfahren zur Herstellung von Beschichtungen durch Aushärtung von thermisch und Strahlen härtbaren Formulierungen nach mindestens einem der vorherigen Ansprüche,
**dadurch gekennzeichnet,**
**dass** als Komponente A) Reaktivverdünner enthalten sind.

6. Verfahren zur Herstellung von Beschichtungen durch Aushärtung von thermisch und Strahlen härtbaren Formulierungen nach Anspruch 5,
**dadurch gekennzeichnet,**
**dass** Isobornylacrylat, Hydroxypropylmethacrylat, Trimethylolpropanmonoformalacrylat, Tetrahydrofufurylacrylat, Phenoxyethylacrylat Trimethylenpropantriacrylat, Dipropylenglycoldiacrylat, Tripropylenglycoldiacrylat, Hexandioldiacrylat, Pentaerythrittetraacrylat, Laurylacrylat sowie propoxilierte oder ethoxilierte Varianten dieser Reaktivverdünner und/oder urethanisierte Reaktivverdünner Vinylether oder Allylether, allein oder in Mischungen, enthalten sind.

7. Verfahren zur Herstellung von Beschichtungen durch Aushärtung von thermisch und Strahlen härtbaren Formulierungen nach Anspruch 6,
**dadurch gekennzeichnet,**
**dass** Isobornylacrylat und/oder Trimethylolpropanmonoformalacrylat enthalten sind.

8. Verfahren zur Herstellung von Beschichtungen durch Aushärtung von thermisch und Strahlen härtbaren Formulierungen nach mindestens einem der vorherigen Ansprüche,
**dadurch gekennzeichnet, dass** als Komponente A) Mischungen aus Harzen der Komponente A) und monofunktionelle Reaktivverdünner eingesetzt werden.

9. Verfahren zur Herstellung von Beschichtungen durch Aushärtung von thermisch und Strahlen härtbaren Formulierungen nach mindestens einem der vorherigen Ansprüche,
**dadurch gekennzeichnet, dass** als Komponente B) (Oligo[2-hydroxy-2-methyl-1-[4-(1-methylvinyl)phenyl]propanone]) Bis(η5-2,4-cylcopentadien-1-yl)-bis(2,6-difluoro-3-(1H-pyrrol-1-yl)-phenyl)titanium, 1-Hydroxycyclohexyl-phenylketon), 2,2-Dimethoxy-1,2-diphenylethan-1-on, Phenyl-bis(2,4,6-trimethylbenzoyl)-phosphinoxid, 2-Hydroxy-2-benzoylpropan, enthalten sind, allein oder in Mischungen.

10. Verfahren zur Herstellung von Beschichtungen durch Aushärtung von thermisch und Strahlen härtbaren Formulierungen nach mindestens einem der vorherigen Ansprüche,
**dadurch gekennzeichnet,**
**dass** als Komponente C) Haftvermittler, Pigmente, Inhibitoren, Stabilisatoren, Entgasungsmittel, Verlaufmittel, Lösemittel enthalten sind, allein oder in Mischungen.

11. Verfahren zur Herstellung von Beschichtungen durch Aushärtung von thermisch und Strahlen härtbaren Formulierungen nach mindestens einem der vorherigen Ansprüche,
**dadurch gekennzeichnet,**
**dass** die Beschichtung 4 bis 60 Minuten auf eine Temperatur von 60 bis 220 °C, vorzugsweise 6 bis 30 Minuten bei 80 bis 160 °C erhitzt wird, und vollständig thermisch ausgehärtet wird.

## Claims

1. Process for producing coatings by
I) selecting the selected photoinitiator B) according to the following method and with the following condition:
2% by weight of the photoinitiator is dissolved in isobornyl acrylate and 20-80% of the double bonds are free-radically polymerized on a substrate by means of a UV lamp with a layer thickness of 100 µm, to obtain a coating having a maximum in the exothermic peak in degrees Celsius at temperatures less than or equal to 160°C, measured by means of DSC to DIN EN ISO 11357-1;
II) curing thermally curable and radiation-curable formulations composed of
A) 45% to 99.9% by weight of at least one radiation-curable component
and
B) 0.1% to 5% by weight of at least one selected free-radically initiating photoinitiator;
and optionally
C) 0.01% to 50% by weight of at least one additive,
and the sum total of A) and B) and any C) is 100% by weight,
wherein said formulation, after application to a substrate, is cured at least partly with radiation, wherein an average of at least 20% but not more than 95% of the polymerizable double bonds are reacted,
then the coated substrate is processed further, and then the coating on the substrate is heated thermally at from 60 to 220°C, and the coating is cured fully.

2. Process for producing coatings by curing thermally curable and radiation-curable formulations according to Claim 1,
wherein the photoinitiator selected meets the following condition:
2% by weight of the photoinitiator is dissolved in isobornyl acrylate and 20-80% of the double bonds are free-radically polymerized on a substrate by means of a UV lamp with a layer thickness of 100 µm, to obtain a coating having a maximum in the exothermic peak in degrees Celsius at temperatures less than or equal to 160°C, measured by means of DSC to DIN EN ISO 11357-1.

3. Process for producing coatings by curing thermally curable and radiation-curable formulations according to at least one of the preceding claims, **characterized in that**
epoxy acrylates, polyester acrylates, polyether acrylates, polyacrylate acrylates, and urethane acrylates and/or polyester urethane acrylates, alone or in mixtures, are present as resins of component A).

4. Process for producing coatings by curing thermally curable and radiation-curable formulations according to at least one of the preceding claims, **characterized in that**
polyester urethane acrylates are present as component A).

5. Process for producing coatings by curing thermally curable and radiation-curable formulations according to at least one of the preceding claims, **characterized in that**
reactive diluents are present as component A).

6. Process for producing coatings by curing thermally curable and radiation-curable formulations according to Claim 5,
**characterized in that**
isobornyl acrylate, hydroxypropyl methacrylate, trimethylolpropane monoformal acrylate, tetrahydrofurfuryl acrylate, phenoxyethyl acrylate, trimethylenepropane triacrylate, dipropylene glycol diacrylate, tripropylene glycol diacrylate, hexanediol diacrylate, pentaerythritol tetraacrylate, lauryl acrylate, and propoxylated or ethoxylated variants of these reactive diluents and/or urethanized reactive diluents, vinyl ethers or allyl ethers, alone or in mixtures, are present.

7. Process for producing coatings by curing thermally curable and radiation-curable formulations according to Claim 6,
**characterized in that**
isobornyl acrylate and/or trimethylolpropane monoformal acrylate are present.

8. Process for producing coatings by curing thermally curable and radiation-curable formulations according to at least one of the preceding claims, **characterized in that** mixtures of resins of component A) and monofunctional reactive diluents are used as component A).

9. Process for producing coatings by curing thermally curable and radiation-curable formulations according to at least one of the preceding claims, **characterized in that** oligo[2-hydroxy-2-methyl-1-[4-(1-methylvinyl)phenyl]propanone], bis(η⁵-2,4-cyclopentadien-1-yl)-bis(2,6-difluoro-3-(1H-pyrrol-1-yl)phenyl)titanium, 1-hydroxycyclohexyl phenyl ketone, 2,2-dimethoxy-1,2-diphenylethan-1-one, phenylbis(2,4,6-trimethylbenzoyl)phosphine oxide and 2-hydroxy-2-benzoylpropane, alone or in mixtures, are present as component B).

10. Process for producing coatings by curing thermally curable and radiation-curable formulations according to at least one of the preceding claims, **characterized in that**
adhesion promoters, pigments, inhibitors, stabilizers, degassing agents, levelling agents and solvents, alone or in mixtures, are present as component C).

11. Process for producing coatings by curing thermally curable and radiation-curable formulations according to at least one of the preceding claims, **characterized in that**
the coating is heated to a temperature of 60 to 220°C for 4 to 60 minutes, preferably at 80 to 160°C for 6 to 30 minutes, and is fully thermally cured.

## Revendications

1. Procédé pour la préparation de revêtements par
I) le choix du photo-initiateur B) choisi selon le procédé suivant et à la condition suivante :
dissolution de 2% en poids du photo-initiateur dans de l'acrylate d'isobornyle et polymérisation par voie radicalaire, sur un substrat, au moyen d'une lampe UV, de 20-80% des doubles liaisons, à une épaisseur de couche de 100 µm, un revêtement présentant un maximum du pic exothermique, en degrés Celsius, situé à des températures inférieures ou égales à 160°C, mesuré au moyen de DSC (calorimétrie à balayage différentiel) selon la norme DIN EN ISO 11357-1, étant obtenu ;
II) le durcissement de formulations, durcissables par voie thermique et par des rayons, constituées par
A) 45 à 99,9% en poids d'au moins un composant durcissable par des rayons et
B) 0,1 à 5% en poids d'au moins un photo-initiateur choisi, à initier par voie radicalaire ; et le cas échéant
C) 0,01 à 50% en poids d'au moins un additif, et la somme de A) et B) et le cas échéant de C) valant 100% en poids,
cette formulation étant durcie au moins partiellement par des rayons après application sur un substrat, en moyenne au moins 20%, mais au maximum 95%, des doubles liaisons polymérisables étant amenées à réagir, le substrat revêtu étant ensuite transformé ultérieurement et le revêtement sur le substrat étant ensuite chauffé thermiquement à 60 jusqu'à 220°C et le revêtement étant durci complètement.

2. Procédé pour la préparation de revêtements par durcissement de formulations durcissables par voie thermique et par des rayons selon la revendication 1, le photo-initiateur choisi correspondant à la condition suivante :
dissolution de 2% en poids du photo-initiateur dans de l'acrylate d'isobornyle et polymérisation par voie radicalaire, sur un substrat, au moyen d'une lampe UV, de 20-80% des doubles liaisons, à une épaisseur de couche de 100 µm, un revêtement présentant un maximum du pic exothermique, en degrés Celsius, situé à des températures inférieures ou égales à 160°C, mesuré au moyen de DSC (calorimétrie à balayage différentiel) selon la norme DIN EN ISO 11357-1, étant obtenu.

3. Procédé pour la préparation de revêtements par durcissement de formulations durcissables par voie thermique et par des rayons selon au moins l'une quelconque des revendications précédentes, **caractérisé en ce que** des époxyacrylates, des polyesteracrylates, des polyétheracrylates, des polyacrylate-acrylates et des acrylates d'uréthane et/ou des polyester-acrylates d'uréthane, seuls ou en mélange, sont contenus comme résines du composant A).

4. Procédé pour la préparation de revêtements par durcissement de formulations durcissables par voie thermique et par des rayons selon au moins l'une quelconque des revendications précédentes, **caractérisé en ce que** des polyester-acrylates d'uréthane sont contenus comme composant A).

5. Procédé pour la préparation de revêtements par durcissement de formulations durcissables par voie thermique et par des rayons selon au moins l'une quelconque des revendications précédentes, **caractérisé en ce que** des diluants réactifs sont contenus comme composant A).

6. Procédé pour la préparation de revêtements par durcissement de formulations durcissables par voie thermique et par des rayons selon la revendication 5, **caractérisé en ce que** de l'acrylate d'isobornyle, du méthacrylate d'hydroxypropyle, du monoformalacrylate de triméthylolpropane, de l'acrylate de tétrahydrofurfuryle, de l'acrylate de phénoxyéthyle, du triacrylate de triméthylènepropane, du diacrylate de dipropylèneglycol, du diacrylate de tripropylèneglycol, du diacrylate d'hexanediol, du tétraacrylate de pentaérythritol, de l'acrylate de lauryle ainsi que des variantes propoxylées ou éthoxylées de ces diluants réactifs et/ou des diluants réactifs uréthanisés, du vinyléther ou de l'allyléther, seuls ou en mélange, sont contenus.

7. Procédé pour la préparation de revêtements par durcissement de formulations durcissables par voie thermique et par des rayons selon la revendication 6, **caractérisé en ce que** de l'acrylate d'isobornyle et/ou du monoformalacrylate de triméthylolpropane sont contenus.

8. Procédé pour la préparation de revêtements par durcissement de formulations durcissables par voie thermique et par des rayons selon au moins l'une quelconque des revendications précédentes, **caractérisé en ce qu'**on utilise, comme composant A), des mélanges de résines du composant A) et de diluants réactifs monofonctionnels.

9. Procédé pour la préparation de revêtements par durcissement de formulations durcissables par voie thermique et par des rayons selon au moins l'une quelconque des revendications précédentes, **caractérisé en ce que** de l'(oligo[2-hydroxy-2-méthyl-1-[4-(1-méthylvinyl)phényl]propanone]), du bis(η5-2,4-cylcopentadién-1-yl)-bis(2,6-difluoro-3-(1H-pyrrol-1-yl)-phényl)titanium, de la 1-hydroxycyclohexylphénylcétone), de la 2,2-diméthoxy-1,2-diphényléthan-1-one, du phényl-bis(2,4,6-triméthylbenzoyl)-phosphinoxyde, du 2-hydroxy-2-benzoylpropane, seuls ou en mélange, sont contenus comme composant B).

10. Procédé pour la préparation de revêtements par durcissement de formulations durcissables par voie thermique et par des rayons selon au moins l'une quelconque des revendications précédentes, **caractérisé en ce que** des promoteurs d'adhérence, des pigments, des inhibiteurs, des stabilisants, les agents de dégazage, des agents d'étalement, des solvants, seuls ou en mélange, sont contenus comme composant C).

11. Procédé pour la préparation de revêtements par durcissement de formulations durcissables par voie thermique et par des rayons selon au moins l'une quelconque des revendications précédentes, **caractérisé en ce que** le revêtement est chauffé pendant 4 à 60 minutes à une température de 60 à 220°C, de préférence pendant 6 à 30 minutes à 80 jusqu'à 160°C, et est durci complètement par voie thermique.
